## Europäisches Patentamt

## European Patent Office

## Office européen des brevets

(11) Veröffentlichungsnummer: **0 078 892**
**B1**

# EUROPÄISCHE PATENTSCHRIFT

(45) Veröffentlichungstag der Patentschrift:
**02.09.87**

(21) Anmeldenummer: **82107531.4**

(22) Anmeldetag: **18.08.82**

(51) Int. Cl.⁴: **G 01 D 5/249, H 03 M 1/22**

(54) **Wegmesseinrichtung mit Referenzmarken.**

(30) Priorität: **07.11.81 DE 3144334**

(43) Veröffentlichungstag der Anmeldung:
**18.05.83 Patentblatt 83/20**

(45) Bekanntmachung des Hinweises auf die Patenterteilung:
**02.09.87 Patentblatt 87/36**

(84) Benannte Vertragsstaaten:
**AT CH FR GB IT LI NL SE**

(56) Entgegenhaltungen:
**EP-A-0 013 799**
**DE-A-1 814 785**
**DE-A-2 103 196**
**DE-A-2 416 212**

(73) Patentinhaber: **Dr. Johannes Heidenhain GmbH, Nansenstrasse 17, D-8225 Traunreut (DE)**

(72) Erfinder: **Schmitt, Walter, Ing. grad., Hochgernstrasse 22, D-8225 Traunreut (DE)**

LIBER, STOCKHOLM 1987

## Beschreibung

Die Erfindung bezieht sich auf ein Wegmeßgerät nach dem Oberbegriff des Anspruches 1.

Derartige Wegmeßgeräte sind bekannt. So ist es aus der DE-A- 24 16 212 bekannt, bei einer inkrementalen Längen- und/oder Winkelmeßeinrichtung auf einer gesonderten Spur neben der Inkremental-Meßtellung Referenzmarken vorzusehen, die als Absolutwert-Markierungen dienen. Dabei unterscheiden sich die Abstände der einzelen Referenzmarken voneinander. Durch Abtastung der inkrementalen Teilung kann der individuelle Abstand zweier Referenzmarken jeweils aus der Summe der Inkremente zwischen zwei Referenzmarken ermittelt werden. Diese durch Auszählung ermittelte Summe stellt die Kennung für die Referenzmarken dar. Zur Ermittlung der Kennzeichnung einer Referenzmarke und ihrer absoluten Position müssen also immer zwei Referenzmarken bei der Abtastung überfahren werden. Dieses Verfahren ist umständlich und zeitraubend, wenn beispielweise zwei Referenzmarken weit auseinander liegen. Zudem können bei fehlerhafter Zählung der Inkremente zwischen zwei Marken falsche Abstände ermittelt und damit falsche Absolutwerte gebildet werden.

Der Erfindung ließt die Aufgabe zugrunde, Wegmeßeinrichtungen mit Referenzmarken zu verbessern, die Auswertung der Referenzmarken zu erleichtern und sicherer zu machen.

Diese Aufgabe wird bei einer Einrichtung der eingangs genannten Art durch die im Kennzeichen des Anspruches 1 angegebenen Merkmale gelöst.

Die abhängigen Ansprüche geben vorteilhafte Ausgestaltungen der Erfindung an.

Die besonderen Vorteile der Erfindung liegen in der sicheren Erkennung der spezifischen Referenzmarke durch die vorherige Auswertung der zugehörigen Codeinformation. Durch die in der Codeinformation enthaltenen Daten kann die Auswerteeinrichtung auf das Erscheinen der nächsten, bestimmten Referenzmarke vorbereitet werden. Zur eindeutigen Bestimmung einer Referenzmarke braucht nur diese eine Referenzmarke und deren benachbarte Codeinformation überfahren zu werden.

Nachstehend wird die Erfindung mit Hilfe eines Beispiels anhand der Zeichnung erläutert.

Es zeigen

Figur 1 eine Maßverkörperung mit Skalenspuren,

Figur 2 ein Signaldiagramm von Abtastsignalen bei Abtastung der Maßverkörperung gemäß Figur 1,

Figur 3 eine Schaltungsanordnung zur Auswertung von Abtastsignalen gemäß Figur 2.

Eine Maßverkörperung 1 einer nicht näher dargestellten lichtelektrischen inkrementalen Längenmeßeinrichtung trägt neben der periodisch strukturierten Meßteilungsspur 2 eine Referenzmarkenspur 3. Eine Abtasteinrichtung 4 mit Abtastfeldern 5 und 6 tastet sowohl die inkrementale Teilungsspur 2 als auch die Referenzmarkenspur 3 ab. Von der Abtasteinrichtung 4 während der Relativbewegung von Maßverkörperung 1 und Abtasteinrichtung 4 erzeugte Signale werden einem elektronischen Zähler 7 zur Auswertung zugeführt.

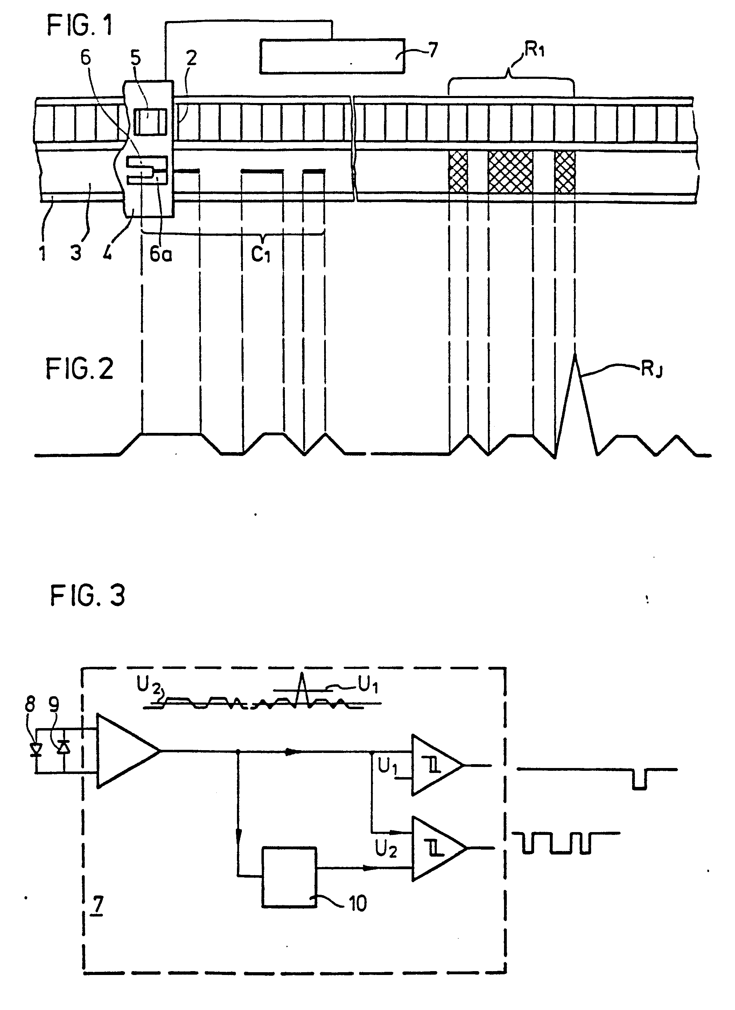

Die Maßverkörperung 1 trägt auf der Referenzmarkenspur 3 eine Reihe von Referenzmarken $R_1...R_n$, von denen hier aus Platzgründen nur die Referenzmarke $R_1$ dargestellt ist. Der besondere Aufbau, d. h. das Strich-/Lückenverhältnis derartiger Referenzmarken und ihrer Abtastfelder ist in der DE-A-18 14 785, dort Fig. 2, dargestellt und beschrieben.

Jedesmal, wenn die Abtasteinrichtung 4 eine der Referenzmarken $R_1...R_n$ überfährt, gelangt die Referenzmarke $R_1...R_n$ zur Wirkung und ein Referenzimpuls $R_J$ wird in den Zähler Z eingespeist. Mit den so gewonnenen Referenzimpulsen $R_J$ können verschiedene Funktionen ausgelöst werden. Sehr häufig wird durch die Auswertung der Referenzimpulse $R_J$ aus der inkrementalen Meßeinrichtung eine quasi absolute Meßeinrichtung, wenn jeder Referenzmarke $R_1...R_n$ eine Zahl zugeordnet wird, die deren absolute Position, bezogen auf einen unveränderlichen Nullpunkt, darstellt. Oder es kann eine bestimmte Referenzmarke $R_x$ dazu herangezogen werden, den Zähler beim Auftreten des aus der bestimmten Referenzmarke $R_x$ abgeleiteten Referenzimpulses $R_J$ auf den Wert "Null" zu stellen.

Alle diese Funktionen sind aber nur durchführbar, wenn auch aus der Reihe von Referenzmarken $R_1...R_n$ jede einzelne die ausgewählt werden soll, als die eine bestimmte Referenzmarke $R_x$ erkannt wird.

Zur Identifizierung jeder einzelnen Referenzmarke $R_1...R_n$ ist daher auf der Maßverkörperung 1 jeweils eine zur jeweiligen Referenzmarke $R_1...R_n$ gehörige Codeinformation $C_1...C_n$ seriell angeordnet. In diesen Codeinformationen $C_1...C_n$ sind alle Informationen enthalten, die zur Identifizierung der zugehörigen Referenzmarke erforderlich sind. Des weiteren sind Start-/Stoppinformationen vorgesehen, die die Auswerteschaltung im Zähler 7 aktivieren, d. h. darauf vorbereiten, daß im Anschluß an die Startinformation eine Codeinformation ausgelesen wird. Die Stoppinformation dient dazu, sicherzustellen, daß auch die gesamte Codeinformation abgelesen wurde. Eine derartige "Quittierung" ist sinnvoll, da ja beim Meßvorgang eventuell mitten in der Abtastung der Codeinformation $C_1...C_n$ die Relativbewegung zwischen Abtasteinrichtung 4 und Maßverkörperung 1 gestoppt und die Bewegungsrichtung umgekehrt werden kann.

Die Abtastung der Codeinformation $C_1...C_n$ erfolgt also immer vor dem Erreichen der zugehörigen Referenzmarke $R_1...R_n$. Da die Codeinformationen $C_1...C_n$ die speziellen

Identifizierungsmerkmale für die Referenzmarken $R_1...R_n$ enthalten, läßt sich durch die richtungsabhängige Auswertung der Informationen auch mit Sicherheit die richtige Referenzmarke $R_1...R_n$ bestimmen.

Wenn davon ausgegangen wird, daß die Abtasteinrichtung 4 die Maßverkörperung 1 in positiver Richtung von links nach rechts überfährt, so folgt auf die Darstellung gemäß der Figuren 1 und 2 als nächstes die Codeinformation $C_2$, dazu die Referenzmarke $R_2$, ... die Codeinformation $C_{n-1}$, die Referenzmarke $R_{n-1}$, dann die Codeinformation $C_n$ und dann die Referenzmarke $R_n$. Bei negativer Abtastbewegung, d. h. von rechts nach links, kann also erkannt werden, daß nach der Codeinformation $C_n$ die Referenzmarke $R_{n-1}$ folgen muß usw.

Gleichgültig von welcher Richtung aus die Abtasteinrichtung 4 die nächste Referenzmarke $R_1...R_n$ überfahren wird, zur eindeutigen Bestimmung einer speziellen Referenzmarke $R_x$ reicht das Überfahren einer Codeinformation $C_x$ oder $C_{x+1}$ aus, um die Auswerteeinrichtung 7 auf diese spezielle Referenzmarke $R_x$ vorzubereiten.

Die Auswerteeinrichtung 7 kann eine Auswahleinrichtung enthalten, mit deren Hilfe ganz bestimmte Referenzmarken $R_x$ aus der Mehrzahl der Referenzmarken $R_1....R_n$ ausgewählt und zur Wirkung gebracht werden können.

Auf der Referenzmarkenspur 3 werden die Codeinformationen $C_1...C_n$ und die Referenzmarken $R_1...R_n$ als ganzzahliger Teil oder als ganzzahliges Vielfaches der inkrementalen Meßteilung aufgebracht. So ist gewährleistet, daß die Auslesung der Informationen der Referenzmarkenspur 3 im Takt der Abtastung der Meßteilungsspur 2 erfolgt. Die Referenzmarkenspur 3 läßt sich auch als Spur gestalten, bei der wie bei der Meßteilungsspur 2 periodisch Hell-/Dunkelfelder aufgebracht sind. Nach der standardmäßigen Herstellung einer solchen Maßverkörperung 1 lassen sich anschließend die individuellen Codeinformationen durch partielles Abätzen der Dunkelfelder bzw. Abdecken der Hellfelder auf der Spur aufbringen. Dieses Verfahren erleichtert die Lagerhaltung der Maßverkörperung 1.

Durch die standardmäßige Herstellung der Maßverkörperung 1 lassen sich nach dem Aufbringen der Teilungen aus der Maßverkörperung 1 einzelne Anschnitte herausschneiden und die Abschnitte können jeder für sich mit Codeinformationen versehen werden. Damit kann die Ausschußquote verringert werden. Sind beispielsweise bei einer längeren Maßverkörperung nach dem Stand der Technik (DE-A- 24 16 212) die Referenzmarken in unterschiedlichen Abständen voneinander aufgebracht und auf den Nullpunkt bezogen, ist die gesamte Maßverkörperung unbrauchbar, wenn sich irgendwo auf der Maßverkörperung eine fehlerhafte Teilungsstelle befindet. Ist jedoch irgendeine fehlerhafte Teilungsstelle auf der vorbeschriebenen erfindungsgemäßen Maßverkörperung 1, so können aus der gesamten Maßverkörperung 1 die schlechten Bereiche herausgeschnitten werden, und man erhält entsprechend viele kleinere Maßverkörperungsabschnitte, auf die anschließend Codeinformationen in der vorbeschriebenen Weise aufgebracht werden. Diese Abschnitte sind voll tauglich für kleinere Meßlängen.

Dei lichtelektrischen Wegmeßeinrichtungen kann es durch Altern der Lampe oder durch Verschmutzung optischer Bauelemente zu Helligkeitsveränderungen kommen, die zu Problemen bei der Auswertung der Abtastsignale führen können. Die Schaltung gemäß Figur 3 dient zur selbsttätigen Anpassung der Triggerschwellen für die Signale, die durch die Abtastung der Referenzmarkenspur 3 gewonnen werden. Dazu muß die Abtasteinrichtung 4 über eine Referenzmarke $R_1...R_n$ gefahren werden.

Die bei dem so erzeugten Referenzimpuls $R_J$ auftretenden Amplituden sind charakteristisch für die optischen Verhältnisse zu diesem Zeitpunkt. Die Triggerschwelle $U_1$ für den Referenzimpuls $R_J$ wird durch Abgleich der Fotoelemente 8 und 9 festgelegt. Durch die außerhalb der individuellen Codeinformation $C_1...C_n$ bestehende Strukturierung der Referenzmarkenspur 3 wird bei der Abtastung wenigstens ein Signal gewonnen, dessen Amplitude in der Anpassungsschaltung 10 zur Auswertung gespeichert wird. Die Anpassungsschaltung 10 ermittelt so die momentane Triggerschwelle $U_2$ für die Signale, die aus der Codeinformation $C_1...C_n$ gewonnen werden, dadurch erfolgt die selbsttätige Anpassung der Triggerschwelle $U_2$ an die jeweilige Amplitude des Abtastsignals.

Verändern sich nun die optischen Verhältnisse bei der Abtastung infolge von Lampenhelligkeitsveränderungen oder Verschmutzung, so wird der Triggerschaltpunkt $U_2$ in entsprechender Weise ebenfalls verändert, so daß die Zuverlässigkeit der Wegmeßeinrichtung gewährleistet bleibt.

Die Erfindung ist auch bei Wegmeßeinrichtungen einsetzbar, die auf einem anderen als dem lichtelektrischen Abtastprinzip beruht. Es ist auch möglich, daß beispielsweise die Abtastung der Meßteilungsspur 2 lichtelektrisch erfolgt, die Abtastung der Referenzmarkenspur 3 hingegen magnetisch vorgenommen wird.

Unter Wegmeßeinrichtungen werden Längen- und Winkelmeßeinrichtung verstanden.

## Patentansprüche

1. Wegmeßeinrichtung mit einer Maßverkörperung (1) und einer Abtasteinrichtung (4) zur Abtastung der Maßverkörperung (1), welche eine Meßteilungssungsspur (2) und wenigstens eine Referenzmarkenspur (3) mit einer Mehrzahl von Referenzmarken (R₁...Rₙ) aufweist, sowie mit einer mit der Abtasteinrichtung (4) in Verbindung stehenden Auswerteeinrichtung (7), dadurch gekennzeichnet, daß jeder der Referenzmarken (R₁...Rₙ) seriell wenigstens eine Codeinformation (C₁...Cₙ) zugeordnet ist, und daß jede der Codeinformationen C₁...Cₙ in Reihe mit der zugehörigen Referenzmarke (R₁...Rₙ) vorgesehen ist.

2. Wegmeßeinrichtung nach Anspruch 1, dadurch gekennzeichnet, daß die jeweilige serielle Codeinformation (C₁...Cₙ) auf der Referenzmarkenspur (3) in unmittelbarer Nähe der zugehörigen Referenzmarke (R₁...Rₙ) aufgebracht ist.

3. Wegmeßeinrichtung nach Anspruch 1, dadurch gekennzeichnet, daß die jeweilige serielle Codeinformation (C₁...Cₙ) auf einer Gegentaktspur zur Referenzmarkenspur (3) in unmittelbarer Nähe der zugehörigen Referenzmarke (R₁...Rₙ) aufgebracht ist.

4. Wegmeßeinrichtung nach Anspruch 1, dadurch gekennzeichnet, daß die Codeinformationen (C₁...Cₙ) außer den Identifizierungsmerkmalen für die zugehörigen Referenzmarken (R₁...Rₙ) vollständigkeitserkennung aufweist.

5. Wegmeßeinrichtung nach Anspruch 3, dadurch gekennzeichnet, daß die Referenzmarkenspur (3) oder die Gegentaktspur eine Teilung aufweist, deren Teilungsperiode ein ganzzahliger Teil oder ein ganzzahliges Vielfaches der Teilungsperiode der Meßteilung (2) ist.

6. Wegmeßeinrichtung nach den Ansprüchen 3 und 5, dadurch gekennzeichnet, daß das Abtastfeld (6) zur Erzeugung des Gegentaktsignals der Gegentaktspur eine Einschnürung (6a) auf ein ganzzahliges Teil oder ein ganzzahliges Vielfaches der Teilungsperiode der Meßteilung (2) aufweist.

7. Wegmeßeinrichtung nach Anspruch 1, dadurch gekennzeichnet, daß die Auswerteeinrichtung (7) eine Anpassungsschaltung (8) enthält, die die Triggerschwellen für die Signalauswertung selbsttätig an die tatsächlichen Amplituden der Signale anpaßt.

## Claims

1. Distance-measuring device comprising a material measure (1) and a scanning device (4) for scanning the material measure (1) which is provided with a measuring graduation track (2) and at least one reference mark track (3) having a plurality of reference marks (R1...Rn), and comprising an evaluating device (7) which is connected to the scanning device (4), characterized in that each of the reference marks (R₁...Rₙ) is serially associated with at least one code information (C₁...Cₙ) and that each of the code information items (C₁...Cₙ) is provided in series with the associated reference mark (R₁...Rₙ).

2. Distance-measuring device according to Claim 1, characterized in that the respective seria code information (C₁...Cₙ) on the reference mark track (3) is applied in the immediate vicinity of the associated reference mark (R₁...Rₙ).

3. Distance-measuring device according to Claim 1, characterized in that the respective serial code information (C...Cₙ) is applied on a push-pull track with respect to the reference mark track (3) in the immediate vicinity of the associated reference mark (R₁...Rₙ).

4. Distance-measuring device according to Claim 1, characterized in that the code information items (C₁..Cₙ), in addition to the identification characteristics for the associated reference marks (R₁...Rₙ) also contain at least information items for the detection of completeness.

5. Distance-measuring device according to Claim 3, characterized in that the reference mark track (3) or the push-pull track is provided with a graduation, the graduation period of which is an integral part or an integral multiple of the graduation period of the measuring graduation (2).

6. Distance-measuring device according to Claims 3 and 5, characterized in that the scanning field (6) for generating the push-pull signal of the push-pull track is provided with a constriction (6a) to an integral part or an integral multiple of the graduation period of the measuring graduation (2).

7. Distance-measuring device according to Claim 1, characterized in that the evaluating device (7) contains a matching circuit (8) which automatically matches the trigger thresholds for the signal evaluation to the actual amplitudes of the signals.

## Revendications

1. Dispositif de mesure de déplacement comprenant une échelle de mesure (1), un dispositif de balayage (4) pour le balayage de l'échelle de mesure (1) qui présente une piste de graduation de mesure (2) et au moins une piste de repères de référence (3) avec plusieurs repères de référence (R₁...Rₙ), ainsi qu'un dispositif de dépouillement (7) relié au dispositif de balayage (4), caractérisé en ce qu'à chaque repère de référence (R₁...Rₙ) est associée de façon sérielle au moins une information codée (C₁...Cₙ) et en ce que chacune des informations codées (C₁...Cₙ) est prévue en série avec le repère de référence (R₁...Rₙ) associé.

2. Dispositif de mesure de déplacement selon la revendication 1, caractérisé en ce que chaque information codée sérielle (C₁...Cₙ) est disposée sur la piste de repère de référence (3) à proximité immédiate du repère de référence (R₁...Rₙ) associé.

3. Dispositif de mesure de déplacement selon la revendication 1, caractérisé en ce que chaque information codée sérielle ($C_1...C_n$) est disposée sur une piste symétrique par rapport à la piste de repère de référence (3) à proximité immédiate du repère de référence ($R_1...R_n$) associé.

4. Dispositif de mesure de déplacement selon la revendication 1, caractérisé en ce que les informations codées ($C_1...C_n$) présentent, en plus des caractéristiques d'identification pour les repères de référence ($R_1...R_n$) associés, au moins des informations pour l'identification d'intégralité.

5. Dispositif de mesure de déplacement selon la revendication 3, caractérisé en ce que la piste de référence (3) ou la piste symétrique présente une graduation dont la période est une fraction entière ou un multiple entier de la période de la graduation de mesure (2).

6. Dispositif de mesure de déplacement selon les revendications 3 et 5, caractérisé en ce que, pour la génération du signal symétrique de la piste symétrique, la zone de balayage (6) présence un rétrécissement (6a) à une fraction entière ou à un multiple entier de la période de la graduation de mesure (2).

7. Dispositif de mesure de déplacement selon la revendication 1 caractérisé en ce que le dispositif de dépouillement (7) comprend un circuit d'adaptation (8) qui adapte de façon automatique les seuils de déclenchement pour le dépouillement des signaux aux amplitudes réelles des signaux.

FIG. 1

FIG. 2

FIG. 3